# EUROPEAN PATENT APPLICATION

(11) **EP 0 576 182 A1**
(43) Date of publication of application: **29.12.1993**
(21) Application number: 93304576.7
(22) Date of filing: 11.06.1993
(51) Int. Cl.: H01L 23/047, H01L 25/04, H02M 7/48

(54) **A semiconductor device**

(30) Priority: 26.06.1992 JP 168040/92
(71) Applicant: FUJI ELECTRIC CO. LTD., Kawasaki 210 (JP)
(72) Inventor: Miyashita, Shuji, Matumoto-city, Nagano 390 (JP)
(74) Representative: Topley, Paul

(57) **Abstract**

In a semiconductor device made up of power transistor modules (6) and (7) comprising one-set semiconductor elements (transistors) contained in a case, with the main terminals (3) (collector terminal C and emitter terminal E) and the auxiliary terminals (4) (drive signal input terminals) drawn from electrodes in the semiconductor elements and disposed on the upper face of the case, wherein the main terminals and the auxiliary terminals are arranged on the same plane at the same height without disposing partitions between the terminals, and when the modules (6) and (7) are used in pairs and interconnected, the main terminals equipped on each module are arranged in mutually reverse order, and the printed wiring board (8) is mounted on the terminals to achieve external wiring between the modules.

## Description

The present invention relates to the configuration of a semiconductor device intended for a power transistor module used with an inverter.

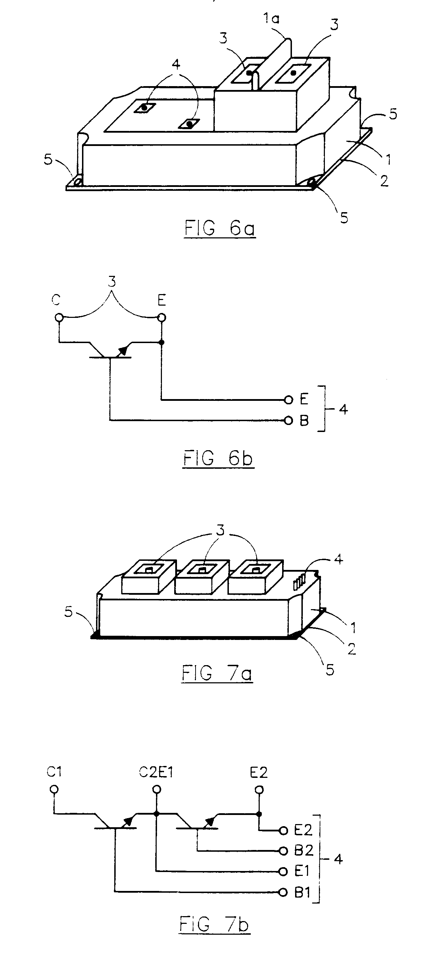

These days, power transistor modules with diverse specifications and configurations used in the field of power electronics are produced commercially. Figures 6 and 7 show examples of conventional power transistor modules, Figure 6 showing a one-set module, and Figure 7 showing a two-set module. The appearance of the modules is shown in Figures 6a and 7a and the internal circuit in Figures 6b and 7b. Actual products use the transistors in Darlington connection and contain high-speed diodes for free wheeling between a collector and an emitter. In each Figure, the part referenced 1 is a resin case, 2 is a metallic base plate, 3 are the main terminals for a collector terminal C and an emitter terminal E, 4 are auxiliary terminals for a drive signal input, and 5 are case fixing screw holes disposed on the four upper corners of the case 1. The main terminals 3 and the auxiliary terminals 4 are disposed on the top of the case 1, and the auxiliary terminals 4 are arranged in a position one-step lower than the main terminals. In the structure shown in Figure 6, a partition 1a is disposed between the main terminals 3 to ensure a sufficient insulation creepage distance. In contrast, the structure shown in Figure 7 has grooves formed among the main terminals 3.

When assembling circuits such as for an inverter combining two or more transistor modules with the above structures, the transistor modules are either interconnected in series or parallel by connecting the main terminals with busbars.

Recent trends in manufacturing products such as inverters are popularising a method of assembling products using automatic mounting in assembly lines, while attempts are made to use printed wiring boards to interconnect transistor modules, for example in place of conventional busbars in order to simplify the process to match the above method. To explain, mounting transistor modules on a printed wiring board on which necessary conductor patterns for the main circuit have been formed initially can greatly reduce the number of parts and the assembly manhours compared with a busbar wiring system, and a snubber circuit and a control circuit can be mounted on the printed wiring board at the same time enabling products to be made more compact.

Incidentally, the following problems need to be solved for transistor modules of conventional structure, shown in Figures 6 and 7, when a printed wiring board is used for wiring the modules. That is, in conventional structures, the height of the main terminals 3 and the auxiliary terminals 4 are different, and especially in the structure in Figure 6 the partition 1a protrudes from between the main terminals 3, wherein the printed wiring board 8 cannot be mounted close to the casings of the transistor modules because of the partition 1a acts as an obstacle, and the printed wiring board cannot be connected directly to the terminals by screw connections.

Another problem is that while the case fixing screw holes 5 are disposed on the four upper corners of the case 1, if the number of holes is to be reduced to two, the auxiliary terminals 4 disposed in a lateral line on the edge of the case 1 form an obstacle and make the provision of screw holes with the same diameter as the conventional holes at the centres of both edges of the case 1 difficult in terms of dimensional restriction.

The present invention has been made in light of these problems, and its objective is to solve said problems and provide a semiconductor device with good assembling workability suitable for mounting modules on a printed wiring board employed for interconnecting the modules when assembling inverter circuits using two or more transistor modules.

The above objectives are achieved by constructing a semiconductor device using the present invention as follows:
(1) In a semiconductor device comprising one set of semiconductor elements contained in a case, with main terminals and auxiliary terminals drawn from electrodes in the semiconductors and disposed on the upper face of the case, the main terminals and the auxiliary terminals are arranged on the same plane at the same height without disposing partitions between the terminals. The structure may include an embodiment so that when such semiconductors are used in sets of two interconnected in series, the main terminals disposed on each semiconductor are arranged in reverse order relative to each other.
(2) In a semiconductor device comprising two or more sets of semiconductors contained in cases, with main terminals and auxiliary terminals drawn from electrodes in the semiconductors disposed on the upper faces of the respective cases, the main terminals are arranged at the centre of the top of the cases in one row and at the same height and the auxiliary terminals are concentrated at the side of the main terminals.
(3) In a semiconductor device containing at least one set of semiconductor elements in a case, with the main terminals and auxiliary terminals drawn from electrodes in the semiconductor disposed on the top of the case, and interconnecting printed wiring boards mounted on the case, the main terminals are arranged at the same height, and the auxiliary terminals are concentrated as fast-on terminals drawn upward to the case from a position one-step lower than the main terminals, and supporting guides for printed wiring boards laid at the same height with the main terminals are disposed on peripherals of the auxiliary terminals.
(4) Further, as an application of the above (3), supporting guides for the connectors, the height of which is equal to the height of the connectors connecting the auxiliary terminals attached to the bottom of the printed wiring boards are disposed.

According to the structure in the foregoing paragraph (1), in which the main terminals and the auxiliary terminals are disposed on the same plane, the printed wiring boards can be directly mounted on the cases, and the main terminals and the auxiliary terminals can be connected directly with conductor patterns formed on the printed wiring boards by screw connection. Further, if such semiconductor devices are used in sets of two and interconnected in series to structure a bridge arm for an inverter, an emitter terminal in one of the transistors and a collector terminal in the other transistor can be wired with a minimum wiring length by arranging the main terminals disposed in each semiconductor device to be in the reverse order to those of the other semiconductor device, for example, the collector terminal and the emitter terminal in the power transistors, with the advantage that wiring inductance can be reduced.

In addition, by adopting the configuration described in the foregoing paragraph (1), it is possible to ensure that the case fixing screw holes are reduced to two and can be positioned at the centres of respective edges of the case.

Further, according to the configuration described in the foregoing paragraphs (3) and (4), when the printed wiring board is mounted on the case of the semiconductor device and the connectors attached to the printed wiring board are connected to the auxiliary terminals in the semiconductor device, it is possible to support the printed wiring board stably because the supporting guide disposed on the semiconductor device case engages and supports the printed wiring board from below, with the advantage that stress imposed on the printed wiring board can be reduced.

Explanations are given hereafter on embodiments of the present invention with reference to the drawings. Parts common to each of the embodiments shown in Figures 6 and 7 are given the same numeral. In the drawings:
Figure 1 shows the configuration for a semiconductor device corresponding to a first embodiment of the present invention;
Figure 2 shows the configuration for a semiconductor device corresponding to a second embodiment of the present invention;
Figure 3 shows the configuration for a semiconductor device corresponding to a third embodiment of the present invention;
Figure 4 shows the configuration for a semiconductor device corresponding to a fourth embodiment of the present invention;
Figure 5 is a perspective view of a supporting guide in the embodiments illustrated in Figures 3 and 4;
Figure 6 shows a one-set power transistor module shown as an example of conventional semiconductor devices, wherein Figure 6a is a perspective view of the configuration and Figure 6b is an internal circuit diagram; and
Figure 7 shows a two-set power transistor module shown as an example of conventional semiconductor devices, wherein Figure 7a is a perspective view of the configuration, and Figure 7b is an internal circuit diagram.

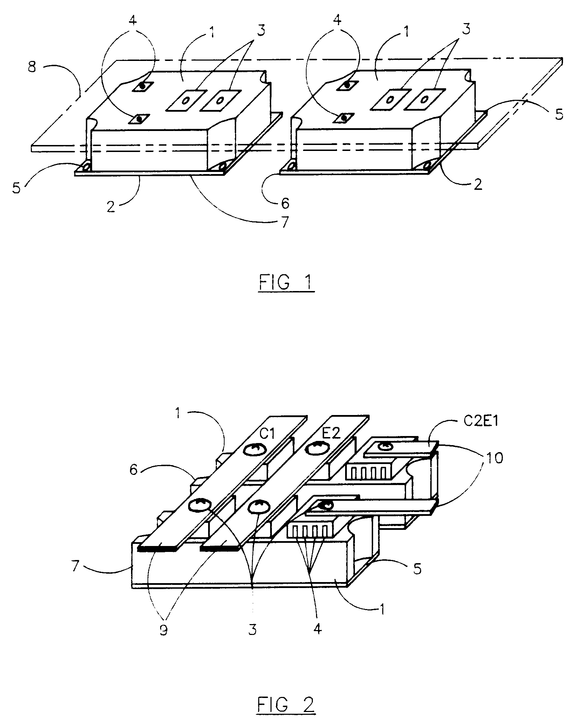

Figure 1 shows a first embodiment of the invention, wherein two power transistor modules 6 and 7 of the same technical specification, containing one set of transistors (corresponding to those shown in Figure 6), are arranged on the right and left sides, and the modules are wired in series via conductor patterns on a printed wiring board 8 spanning over the modules to form a bridge arm in an inverter.

In this structure, cases 1 for the modules 6 and 7 are constructed with a flat top and have their main terminals 3 and auxiliary terminals 4 arranged in the same plane at the same height. The module 6 (on the right-hand side) has the terminals disposed on the case arranged in the same order as the collector terminal C and the emitter terminal E of the main terminal 3 and the auxiliary terminals 4 in a horizontal direction, while the module 7 (on the left-hand side) has the terminals disposed on the case arranged in the reverse order to the auxiliary terminals 4, the collector terminal C, and the emitter terminal E of the main terminals in a horizontal direction.

This structure allows the printed wiring board 8 to be directly fixed on top of the case 1 spanning over the power transistor modules 6 and 7, and moreover, in this condition the main terminals 3 and the auxiliary terminals 4 can be screw-connected to the conductor patterns on the printed wiring board 8. In addition, the collector terminal C on the module 6 and the emitter terminal E on the module 7 are placed adjacent each other with a minimum distance between, enabling these terminals to be connected in series with minimum wiring distance via the conductor patterns on the printed wiring board 8. This structure can reduce wiring inductance.

Figure 2 shows a second embodiment of the invention, wherein the power transistor modules 6 and 7 (corresponding to those in Figure 7), each containing two-set transistors, are disposed in a line and screw-connected to busbars 9 wired across the collector terminal C1 and the emitter terminal E2 of the main terminals 4 in the modules 6 and 7, with the remaining output interim terminals C2 and E1 connected with busbars 10. Also, the internal circuits of the modules 6 and 7 are identical with that shown in Figure 7b.

In this structure, the main terminals 3 (including the collector terminal C1, the emitter terminal E2, and the output interim terminals C2 and E1) are arranged at the same height on the centre of the case top in a row from right to left (as seen in the Figure), and the auxiliary terminals 4 are concentrated to the side of the output interim terminals C2 and E1 on the main terminals 3. Further, in this embodiment, the case fixing screw holes are disposed in two places on both the right and left edges of the case 1 in line with those on the main terminal 3 arrangement, or the centre of both ends of the case 1. In this case, because the auxiliary terminals 4 are disposed at locations off-centre to one side of the case 1, the above screw holes 5 can be drilled without interference from the auxiliary terminals 4. This makes it possible to reduce the number of screw holes 5 from four to two, as distinct from the four which were drilled in the four upper corners of the case 1 in the structure shown in Figure 7.

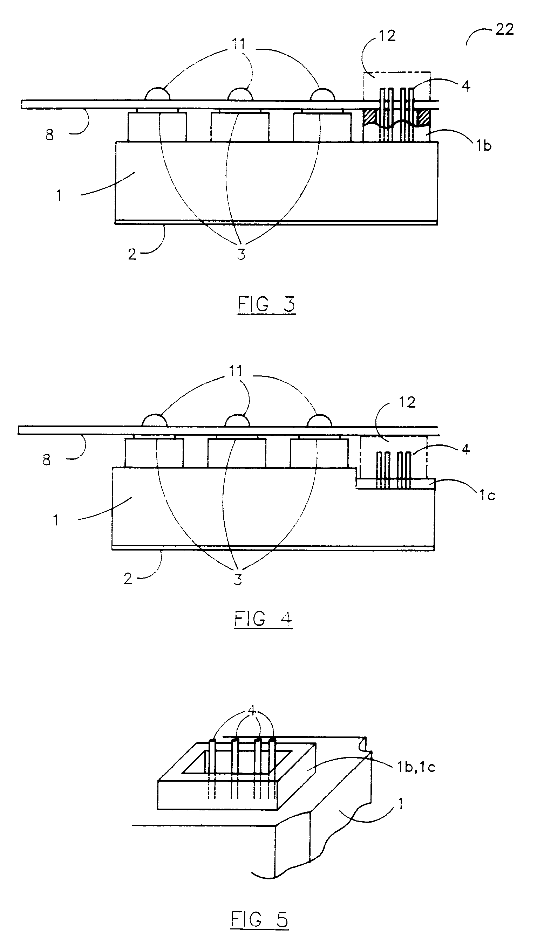

Figure 3 shows a third embodiment of the invention. In this embodiment, the main terminals 3 are arranged at the same height on top of the case 1 of the power transistor module, and the printed wiring board 8 is directly mounted on the main terminals 3 and attached thereto with screws 11. The auxiliary terminals 4 are arranged as fast-on terminals concentrated at one edge of the case top at a height one-step lower than that of the main terminals 3, being drawn upward. The auxiliary terminals 4 are connected with the printed wiring board 8 by connectors 12 for auxiliary terminal connection attached on top of the printed wiring board 8.

In this structure, a supporting guide 1b for the printed wiring board 8 is disposed at the same height as the main terminals 3 on top of the case 1 to surround the auxiliary terminals 4. A perspective view of the supporting guide 1b is shown in Figure 5. According to this structure, when the printed wiring board 8 is mounted on the main terminals 3, it is possible to ensure a stably fixed condition because the supporting guide 1b engages and supports one end of the printed wiring board from below, enabling the stress imposed on the printed wiring board 8 to be reduced.

Figure 4 shows a fourth embodiment of the invention. This embodiment is an adaptation of the third embodiment described above, wherein the connectors 12 interconnected with the auxiliary terminals 4 on the transistor module are fixed below the printed wiring board 8. Further, in this embodiment a supporting guide 1c of lower height is disposed on top of the case 1 to surround the auxiliary terminals 4. This supporting guide 1c is set lower than the height of the main terminal 3 by a distance equal to the height of the connector 12. When the printed wiring board 8 is disposed on the main terminals 3 directly contacting therewith, and the connectors 12 are linked with the auxiliary terminals 4 at the same time as shown, the bottom face of the connectors 12 is carried on said supporting guide 1c. Thus, the printed wiring board 8 can be fixed stably on the transistor module similarly as described in relation to the third embodiment.

According to the configurations in the present invention as described above, external wiring in semiconductors for power transistor modules can be done easily and simply by replacing the conventional busbar wiring system with a printed wiring board. Moreover, by adopting the configurations set out in each claim, a printed wiring board can be directly disposed on the terminals of a semiconductor, and the terminals can be interconnected with the conductor patterns on the printed wiring board. Thus, an automatic mounting assembly process can be adopted in an assembly process of a product such as an inverter, which can improve the mass-productivity of the product.

## Claims

1. A semiconductor device wherein a of semiconductor elements are contained in a case, with main terminals and auxiliary terminals drawn from electrodes in the semiconductor elements and disposed on the upper face of the case, wherein the main terminals and the auxiliary terminals are arranged substantially in the same plane at the same height without disposing partitions between the terminals.

2. A semiconductor device as claimed in Claim 1 comprising two sets of semiconductors connected in series, wherein the main terminals disposed on each semiconductor are arranged in reverse to each other.

3. A semiconductor device comprising two or more sets of semiconductor elements contained in cases, with main terminals and auxiliary terminals drawn from electrodes in the semiconductors disposed on the upper faces of the case, wherein the main terminals are arranged at the centre of the top of the cases in one row and at the same height, and the auxiliary terminals are concentrated at the side of the main terminals.

4. A semiconductor device containing at least one set of semiconductor elements in a case, with the main terminals and auxiliary terminals drawn from electrodes in the semiconductor disposed on the top of the case, and interconnecting printed wiring boards mounted on the case, wherein the main terminals are arranged at the same height, and the auxiliary terminals are concentrated as fast-on terminals drawn upward to the case from a position one-step lower than the main terminals, and supporting guides for printed wiring boards, laid at the same height as the main terminals, are disposed on the peripherals of the auxiliary terminals.

5. A semiconductor device containing at least one set of semiconductor elements in a case, with the main terminals and auxiliary terminals drawn from electrodes in the semiconductor disposed on the top of the case, and interconnecting printed wiring boards mounted on the case, wherein the main terminals are arranged at the same height, and the auxiliary terminals are concentrated as fast-on terminals drawn out upward to the case from a position one-step lower than the main terminals, and supporting guides for the connectors, the height of which is equal to the height of the connectors connecting the auxiliary terminals attached to the bottom of the printed wiring boards.

6. A semiconductor device substantially as herein described with reference to Figure 1, 2, 3, 4 or 5 of the accompanying drawings.
